Europäisches Patentamt

European Patent Office

Office européen des brevets

(11) Veröffentlichungsnummer: **0 226 904**
**A2**

(12) **EUROPÄISCHE PATENTANMELDUNG**

(21) Anmeldenummer: **86116864.9**

(22) Anmeldetag: **04.12.86**

(51) Int. Cl.⁴: **H01H 13/70**

(30) Priorität: **27.12.85 DE 3546196**
**03.06.86 DE 3618541**

(43) Veröffentlichungstag der Anmeldung:
**01.07.87 Patentblatt 87/27**

(84) Benannte Vertragsstaaten:
**AT BE CH FR GB IT LI LU NL SE**

(71) Anmelder: **Hans Widmaier Fabrik für Apparate
der Fernmelde- und Feinwerktechnik
Koppstrasse 4
D-8000 München 70(DE)**

(72) Erfinder: **Elfert, Fritz, Dipl.-Ing.
Winibaldstrasse 42
D-8190 Wolfratshausen(DE)**

(74) Vertreter: **Dorner, Jörg, Dr.-Ing. et al
Dorner & Hufnagel Patentanwälte
Ortnitstrasse 20
D-8000 München 81(DE)**

(54) **Schaltungsplatte, insbesondere für Tastenwahlblöcke, sowie Verfahren zur Herstellung einer solchen Schaltungsplatte.**

(57) Eine wesentliche Verbilligung bei der Herstellung von Schaltungsplatten, insbesondere für Tastenwahlblöcke, wird dadurch erreicht, daß sowohl die Schaltungsträgerplatte als auch das an ihr vorzusehende Leitermuster und auch Anschlußbereiche zu mehradrigen Kabeln jeweils als Spritzgußgebilde hergestellt werden.

FIG. 1

EP 0 226 904 A2

## Schaltungsplatte, insbesondere für Tastenwahlblöcke, sowie Verfahren zur Herstellung einer solchen Schaltungsplatte.

Die Erfindung betrifft Schaltungsplatten, insbesondere für Tastenwahlblöcke, sowie ein Verfahren zur Herstellung einer solchen Schaltungsplatte.

Bekannte Schaltungsplatten dieser Art enthalten eine aus Isolierwerkstoff bestehende Schaltungsträgerplatte, welche an mindestens einer Oberfläche ein Leitermuster aufweist. Dieses Leitermuster ist bei den bekannten Schaltungsplatten in der Weise gebildet, daß zunächst auf die Schaltungsträgerplatte eine Leiterschicht, bei spielweise eine Kupferfolie, aufkaschiert oder in anderer Weise aufgebracht wird, wonach die Leiterschicht unter Verwendung einer Maske abgeätzt wird, um ein Leitermuster zu erzeugen, welches gegebenenfalls einander gegenüberstehende Kontaktbereiche enthält, die dazu bestimmt sind, zusammen mit Schaltstücken, beispielsweise einer diese Schaltstücke tragenden elastisch verformbaren Schaltfolie einzelne Schalter zu bilden, die jeweils Tasten eines Tastenwahlblockes zugeordnet sind.

Bei den bekannten Schaltungsplatten sind die Leitermuster mit Anschlußbereichen versehen, um die Schaltungsplatte mit weiteren Baueinheiten beispielsweise eines Tastenwahlblockes, verbinden zu können. Zu diesem Zwecke waren die metallischen Leiterbahnen der bekannten Schaltungsplatten entweder mit Kontaktstiften verbunden oder wurden die Schaltungsplatten an einem Rand in eine Steckvorrichtung eingesteckt.

Bisher hat man versucht, die Leitungspfade, welche zu den Kontaktbereichen führen, möglichst niederohmig auszubilden, weshalb die durch Ätzung der Leiterschicht auf der Schaltungsträgerplatte erzeugten Leiterbahnen zusätzlich mit einer weiteren Leiterschicht überdruckt oder überdeckt wurden, derart, daß die Leiterquerschnitte der Leiterbahnen zu den entsprechenden niedrigen Widerständen der Leiterbahnen führten.

Auch hat man eine gesonderte Kohleüberschichtung den Schaltstücken der Schaltfolie gegenüberstehenden Kontakbereiche der Schaltungsträgerplatte vorgesehen, um in Zusammenwirkung mit dem kohleversetzten Material der Schaltstücke eine hohe Lebensdauer des jeweiligen Schalters zu erreichen.

Es zeigt sich jedoch, daß das Herstellungsverfahren zur Bildung solcher Schaltungsplatten aufwendig ist, da eine Reihe von Herstellungsschritten aneinandergereiht werden muß, etwa die Beschichtung der Schaltungsträgerplatte mit einer Leiterschicht, das nachfolgende Maskieren der Leiterschicht, das Abätzen des umgebenden Leitermaterials sowie schließlich das Aufbringen zusätzlicher Leiterschichten zur Erniedrigung des Widerstandes der Leitungspfade. Weiter ergibt sich bei den bekannten Konstruktionen die Schwierigkeit, daß als Schaltungsträgerplatte Schichtpreßstoffplatten eingesetzt werden müssen, die bei der Befestigung an Gehäuseteilen eines elektrischen Gerätes, etwa eines Tastenwahlblockes, sich mit dem Gehäusematerial nicht verbinden und daher zusätzliche Maßnahmen ergriffen werden müssen, um eine sichere Befestigung der betreffenden Schaltungsplatte in dem elektrischen Gerät zu erreichen.

Durch die Erfindung soll die Aufgabe gelöst werden, eine Schaltungsplatte der hier interessierenden Art so auszugestalten, daß die Herstellung wesentlich vereinfacht wird, insbesondere die Verfahrensschritte bei der Herstellung vermindert werden und daß unter Herabsetzung der Herstellungskosten eine insbesondere für Tastenwahlblöcke geeignete, eine ebene Oberfläche aufweisende Schaltungsträgerplatten geschaffen werden.

Durch die Erfindung soll auch die Aufgabe gelöst werden, eine Schaltungsplatte, insbesondere für Tastenwahlblöcke so auszugestalten, daß unter Vereinfachung des Aufbaus und Verbilligung der Herstellung Steckverbindungen zum Anschluß der Leiterbahnen an ein mehradriges Kabel vermieden werden.

Diese Aufgabe wird bei einer Schaltungsplatte, insbesondere für Tastenwahlblöcke, dadurch gelöst, daß die Schaltungsträgerplatte als Kunststoff-Spritzgußteil ausgebildet ist, welche das Leitermuster als innig mit der Schaltungsträgerplatte verbundenes Kunststoff-Spritzgußgebilde aus leitfähigem Kunststoff trägt.

Leitfähiger Kunststoff als Spritzgußmaterial ist dem Fachmann an sich bekannt, wobei die Materialauswahl unter dem Gesichtspunkt der Verbindung zu dem Material der Schaltungsträgerplatte getroffen wird.

Gemäß einer bevorzugten Ausführungsform einer Schaltungsplatte der hier vorgeschlagenen Art ist das Leitermuster in Vertiefungen der Schaltungsträgerplatte derart eingebettet, daß seine Oberfläche mit der benachbarten Oberfläche der Schaltungsträgerplatte mindestens bereichsweise, vorzugsweise aber über die gesamte Oberfläche der Schaltungsträgerplatte hin, bündig ist.

Schaltungsplatten der hier angegebenen Art eignen sich besonders für den Aufbau von Tastaturen in Gestalt von Tastenfeldern, bei denen über der Schaltungsplatte eine Schaltfolie aus elastisch verformbarem Werkstoff angeordnet ist, die mit Kontaktstücken versehen ist, welche an in einer Schnappbewegung verformbaren, kuppelartigen Gebilden der Schaltfolie befestigt sind und dazu bestimmt sind, einen Zwischenraum zwischen Kontaktbereichen des Leitermusters der Schaltungsplatte bei Betätigung eines Tastenstössels zur Verformung der kuppelartigen, schnappbaren Gebilde der Schaltfolie zu überbrükken.

In den Anschlußbereichen des Leitermusters kann der leitfähige Kunststoff von einer isolierenden Umhüllung befreite Leiterenden oder Kontaktenden eines mehradrigen Kabels unmittelbar umgeben.

Vorzugsweise liegen die Anschlußbereiche des Leitermusters auf der Schaltungsplatte im wesentlichen in einer Reihe nebeneinander und das mehradrige Kabel hat die Gestalt eines flexiblen Vielleiter-Bandkabels.

Die den Anschlußbereichen zugeordneten Leiterbahnen können bis zu einem Rand der Schaltungsplatte verlaufen und die Leiter des Kabels bzw. des Vielleiter-Bandkabels Können etwa in der Ebene der Schaltungsplatte verlaufend derart auf die Schaltungsplatte treffen, daß die Leiterenden oder Kontaktenden in den Leitkunststoff der Leiterbahnen hineinragen.

Gemäß einer anderen vorteilhaften Ausführungsform können die Anschlußbereiche innerhalb von mit den Leiterbahnen verbundenen Bohrungen der Schaltungsträgerplatte gelegen sein und die Leiter des Kabels bzw. des Vielleiter-Bandkabels können im wesentlichen senkrecht zur Ebene der Schaltungsplatte verlaufend derart auf die Schaltungsplatte treffen, daß die Leiterenden oder Kontaktenden in die mit dem Leitkunstoff der Leiterbahnen ausgerfüllten Bohrungen der Schaltungsträgerplatte hineinragen.

Vorteilhafte Ausgestaltungen und Weiterbildungen der hier angegebenen Schaltungsplatte sowie ein Verfahren zu Herstellung dieser Schaltungsplatte bilden Gegenstand der dem Anspruch 1 nachgeordneten Ansprüche, deren Inhalt hierdurch ausdrücklich zum Bestandteil der Beschreibung gemacht wird, ohne an dieser Stelle den Wortlaut der Ansprüche zu wiederholen.

Im folgenden werden Ausführungsbeispiele der vorliegend angegebenen Schaltungsplatte sowie eines Verfahrens zu deren Herstellung näher erläutert. Es stellen dar:

Fig. 1 eine perspektivische, schematische, ausschnittsweise Darstellung eines Tastenwahlblockes mit einer Schaltungsplatte der hier angegebenen Art,

Fig. 2a eine Spritzgußform zur Herstellung der Schaltungsträgerplatte für eine Schaltungsplatte gemäß Figur 1,

Fig. 2b eine Spritzgußform zur Herstellung der Schaltungsplatte unter Verwendung der in der Spritzgußform nach Figur 2a hergestellten Schaltungsträgerplatte,

Fig. 3 eine schematische perspektivische Explosionsdarstellung eines Teiles eines Tastenwahlblockes mit einer Schaltungsplatte der vorliegend angegebenen Art,

Fig. 3a eine perspektivische, ausschnittsweise Darstellung der in Figur 3 mit A bezeichneten Einzelheit in vergrößertem Maßstab,

Fig. 4 eine schematische perspektivische Explosionsdarstellung eines Teiles eines Tastenwahlblockes der hier angegebenen Art in einer anderen Ausführungsform,

Fig. 4a eine ausschnittsweise Schnittdarstellung der in Figur 4 mit A bezeichneten Einzelheit,

Fig. 5 eine Schnittdarstellung des in Figur 3 mit A bezeichneten Bereiches gemäß einer Abwandlung,

Fig. 6 eine perspektivische, ausschnittsweise Darstellung des Bereiches A nach Figur 3 gemäß einer wiederum anderen Ausbildung und

Fig. 7 eine teilweise im Schnitt gezeichnete Darstellung des in Figur 4 mit A bezeichneten Bereiches in einer Abwandlung gegenüber Figur 4a.

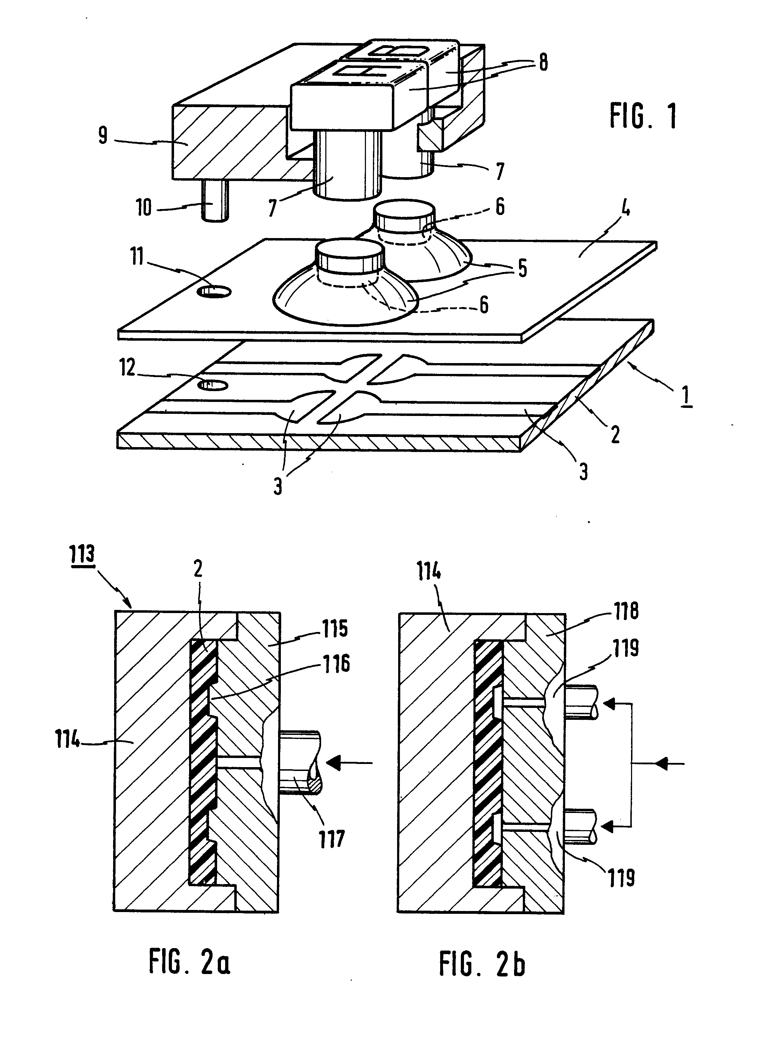

Figur 1 zeigt eine Schaltungsplatte 1, welche aus einer Schaltungsträgerplatte 2 in Gestalt eines Kunststoffspritzgußteiles, sowie einem Leitermuster 3 besteht, das von einem Kunststoffspritzgußgebilde aus einem leitfähigem Kunststoff gebildet ist und in entsprechende Vertiefungen der Schaltungsträgerplatte 3 eingebettet ist.

Bei der in Figur 1 gezeigten Ausführungsform sind die Oberflächen der Schaltungsträgerplatte 2 und des Leitermusters 3 bündig, gemäß einer in den Zeichnungen nicht gezeigten Ausführungsform kann jedoch auch das Leitermuster 3 erhaben auf die Oberfläche der Schaltungsträgerplatte 2 aufgetragen sein. In jedem Falle ist jedoch eine innige Verbindung zwischen der Schaltungsträgerplatte 2 und dem Leitermuster 3 dadurch geschaffen, daß sowohl die Schaltungsträgerplatte als auch das Leitermuster Spritzgußgebilde bzw. Spritzgußteile aus Kunststoff sind, wobei das Leitermuster 3 in entsprechende Ausnehmungen der Schaltungsträgerplatte 2 eingespritzt oder auf die Oberfläche der Schaltungsträgerplatte 2 aufgespritzt ist.

In einem Tastenwahlblock befindet sich über der Schaltunsplatte 1 eine aus elastisch verformbarem Folienmaterial bestehende Schaltfolie 4, welche in an sich bekannter Weise kuppelartige Auswölbungen 5 enthält, welche Kontaktbereichen 6 des Leitermusters 3 gegenüberstehen und welche auf ihrer konkaven Innenseite aus elastisch nachgiebigem Leitkunststoff bestehende Kontakstücke 6 tragen, die einander gegenüberstehende Hälften der Kontaktbereiche 3 des Leitermusters 3 überbrükken, wenn durch eine Betätigungskraft die kuppelförmigen Auswölbungen 5 der Schaltfolie 4 in einer Schnappbewegung zusammengedrückt und die Kontaktstücke 6 auf die Kontaktbereiche 3 niedergedrückt werden.

Zur Betätigung der kuppelartigen Auswölbungen 5 der Schaltfolie 4 dienen Tastenstössel 7 einer Tastenanordnung, wobei die Tastenstössel mit Tasten 8 verbunden sind, die in einem Gehäusedeckel 9 geführt sind. Einzelheiten der Führung der Tasten und der Tastenstössel sind dem Fachmann geläufig und in Figur 1 zur Vereinfachung der Darstellung nicht im einzelnen gezeigt.

Von dem Gehäuse 9 ragen Führungs-und Befestigungsstifte 10 in bestimmter Anzahl nach abwärts und durch Bohrungen oder Durchbrüche 11 der Schaltfolie 4 sowie Bohrungen oder Druchbrüche 12 der Schaltungsplatte 1 hindurch, um die Einzelteile eines Tastenwahlblockes aus den hier beschriebenen Teilen zusammenzuhalten. Das Material des Gehäuses 9 ist auf das Material der Schaltungsträgerplatte 2 abgestimmt oder stimmt mit diesem Material überein, so daß beispielsweise durch Ultraschallschweißung die Führungs-und Befestigungsstifte 10 auf der Rückseite der Schaltungsträgerplatte 2 verschweißt werden können und eine feste Verbindung mit der Schaltungsträgerplatte 2 bilden, wodurch sich ein mechanisch sehr fester Verband der gesamten Konstruktion ergibt.

Die Schaltungsträgerplatte 2 kann in einer in Figur 2a schematisch dargestellten Spritzgußform 113 hergestellt werden, deren Formhälfte 114 mit einer weiteren Formhälfte 115 in Zusammenwirkung gebracht werden kann, welche eine solche Oberflächenprofilierung besitzt, daß sich in dem die Schaltungsträgerplatte 2 darstellenden Spritzgußkörper Vertiefungen 116 an denjenigen Stellen bilden, die später von dem Leitermuster 3 eingenommen werden sollen. Der von der Schaltungsträgerplatte 2 auszufüllende Formhohlraum wird über einen Einguß 117 der Spritzgußform 113 mit einem isolierenden Kunststoff gefüllt.

Danach wird die Formhälfte 114, wie aus Figur 2b ersichtlich ist, einer dritten Formhälfte 118 gegenüber angeordnet, die den die Schaltungsträgerplatte 2 bereits enthaltenden Formhohlraum durch eine ebene Abschlußwand begrenzt, derart, daß die Vertiefungen 116 der Schaltungsträgerplatte 2 durch die ebene Abschlußwand der Formhälfte 118 überdeckt sind. Die auf diese Weise gebildeten Formhohlräume werden über einzelne Eingußkanäle 119 mit elektrisch leitendem Kunststoff gefüllt, um auf diese Weise ein Kunststoff-Spritzgußgebilde zu erzeugen, welches das Leitermuster 3 darstellt. Nach Ausformung erhält man eine Schaltungsplatte, in deren Schaltungsträgerplatte 2 das Leitermuster 3 oberflächenbündig eingebettet ist.

Zwar kann das Leitermuster 3 im Spritzgußverfahren erhaben an eine ebene Oberfläche der Schaltungsträgerplatte 2 angegossen werden, doch erweist sich die Ausführungsform mit einer bündigen Oberfläche des Leitermusters 3 und der Schaltungsträgerplatte 2 als besonders zweckmäßig, wenn die Schaltungsplatte 1 in der in Figur 1 dargestellten Weise mit schnappbaren kuppelartigen Auswölbungen 5 einer Schaltfolie 4 zusammenwirkt, da die Kontaktgabe der Kontaktstücke 6 in solchen Fällen auch nach langer Betriebsdauer besonders zuverlässig ist, in denen sich die Kontaktstücke auf eine ebene, die Kontaktbereiche enthaltende Oberfläche der Schaltungsplatte auflegen können.

Gemäß in der Zeichnung nicht gezeigten Ausführungsformen kann die Schaltungsträgerplatte 2 'mit Durchbrüchen versehen sein, welche bei Herstellung des Kunststoff-Spritzgußgebildes zur Erzeugung des Leitermusters 3 durch elektrisch leitenden Kunststoff ausgefüllt werden, um eine Durchkontaktierung zu erreichen. Auch können die Leiterbereiche, welche an den Oberseiten der Vertiefungen der Schaltungsträgerplatte freiliegen, etwas konvex ausgeführt werden, um eine ordnungsgemäße Kontaktgabe bei der Zusammenwirkung mit beweglichen Kontaktstücken im Bereich von Kontaktelementen des Leitermusters zu erreichen.

Die Einbettung des Leitermusters als Kunststoff-Spritzgußgebilde in zuvor erzeugte, kanalartige Vertiefungen in der Oberfläche der als Spritzgußteil hergestellten Schaltungsträgerplatte hat den Vorteil, daß in verhältnismäßig weiten Grenzen ein beliebiger Leiterquerschnitt der Leiterbahnen des Leitermusters vorgesehen werden kann, so daß ein entsprechend weiter Bereich der spezifischen Leiterwerte der verwendeten leitfähigen Kunststoffe zur Herstellung der Leiterbahnen zur Verfügung steht, ohne daß die Leiterbahnen in unzuträglich starkem Maße über die Oberfläche der Schaltungsträgerplatte auftragen.

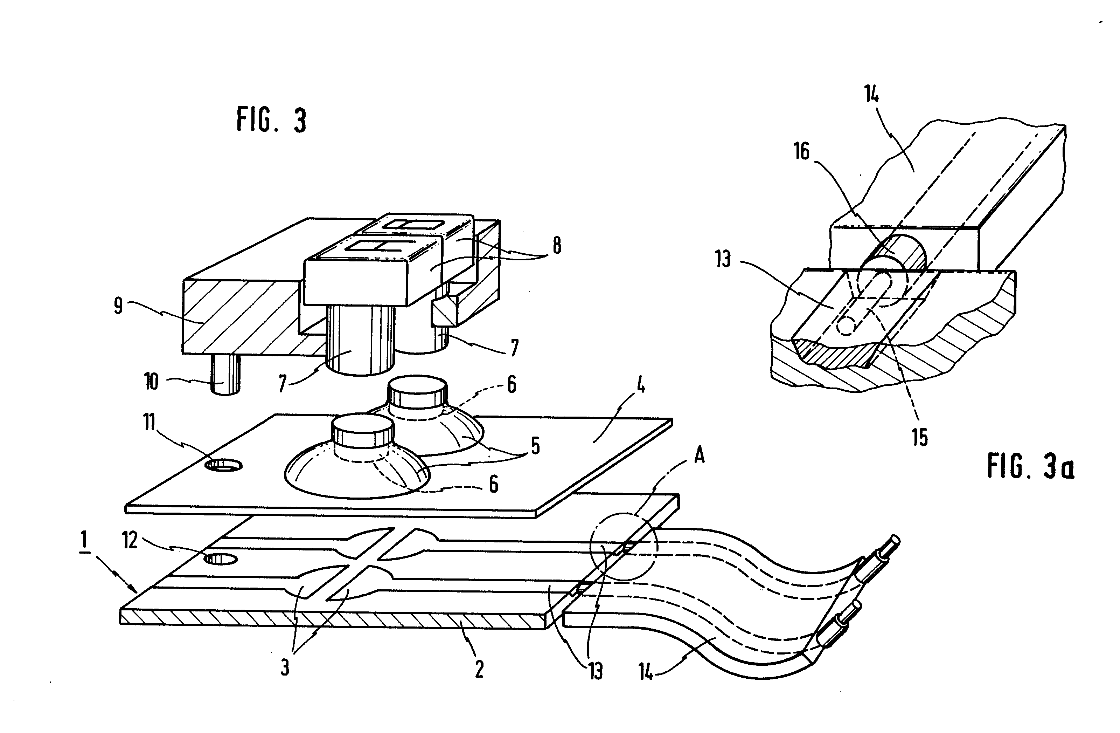

Figur 3 zeigt wiederum eine Schaltungsplatte gemäß Figur 1.

Die Leiterbahnen des Leitermusters 3 sind, wie aus Figur 3 schematisch nur für einen Teil dieser Leiterbahnen dargestellt, zu einer Seitenkante der Schaltungsträgerplatte 2 geführt, so daß an der betreffenden Seitenkante die Querschnitte der in die Vertiefungen der Schaltungsträgerplatte 2 eingebetteten Leiterbahnen freiliegen. Diese Randbereich der Leiterbahnen bilden die Anschlußbereiche der Schaltungsplatte, welche in Figur 3 mit 13 bezeichnet sind. Ein flexibles Vielfachleiter-Bandkabel 14 ist an seinem der Schaltungsträgerplatte 2 benachbarten Ende über die gesamte Breite hin von seinen bandförmigen Isolationslagen auf ein bestimmtes Längenstück befreit, so daß, falls solche vorhanden sind, lediglich die die einzelnen Leiter 15 umhüllenden Isolationsmäntel 16 freiliegen.

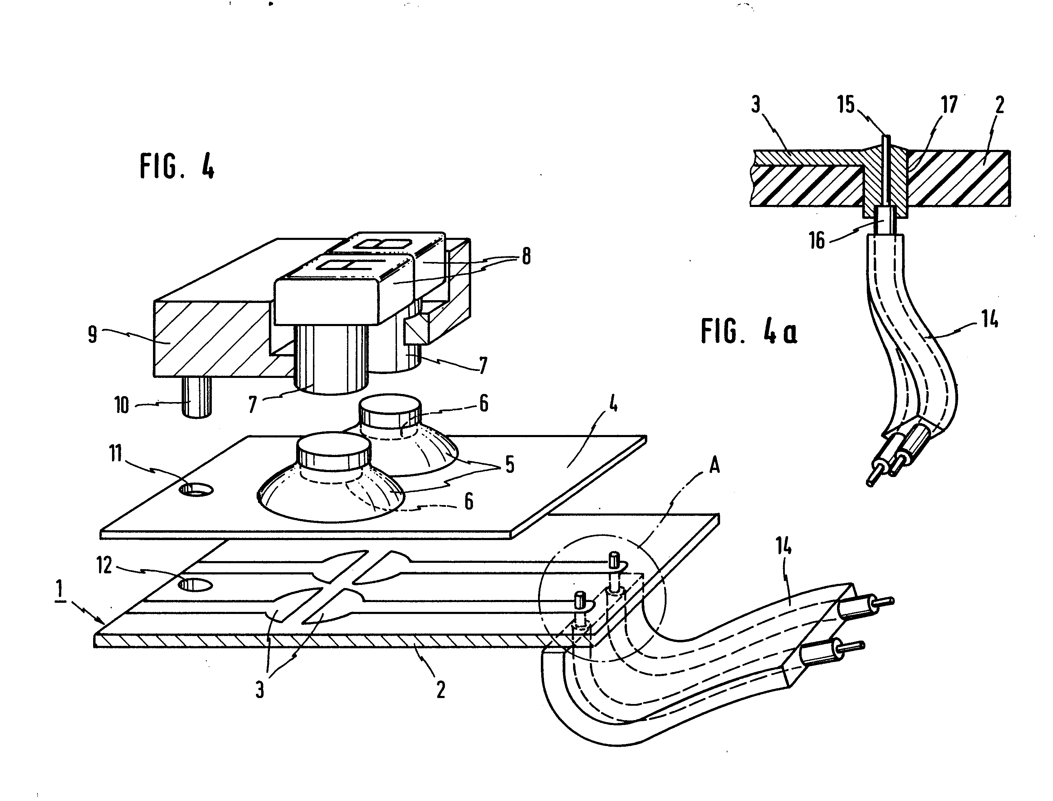

Nachdem in dem Ausführungsbeispiel nach den Figuren 3 und 4 lediglich zwei mit Anschlußbereichen 13 versehene Leiterbahnen des Leitermusters 3 dargestellt sind, hat das mit der Schaltungsplatte verbundene VielleiterBandkabel in der schematischen Darstellung in entsprechender Weise lediglich zwei Leiteradern. Bei praktischen Ausführungsformen sind jedoch beispeilsweise elf Anschlußbereiche für elf mit Anschlüssen zu versehende Leiterbahnen vorgesehen, so daß das Bandkabel 14 in diesen Fällen elf nebeneinanderliegende Leiteradern besitzt.

Die aus der bandförmigen Isolation des Bandkabels hervorstehenden Isolationsmäntel der Leiter 15 sind ebenfalls so weit entfernt, daß freie Längenabschnitte der Leiter 15 aus den Isolationsmänteln 16 vorstehen. Diese Leiterabschnitte ragen in den Leitkunststoff der Leiterbahnen in den Anschlußbereichen 13 hinein und sind von dem im Spritzgußverfahren eingebrachten Leitkunststoff allseitig umgeben. Der Leitkunststoff haftet an dem Leitermaterial der Leiter·15, wodurch eine mechanische und elektrische Verbindung zwischen der Schaltungsplatte 1 und dem Bandkabel 14 hergestellt ist.

Man erkennt, daß die Spritzgußform zur Herstellung des Kunststoff-Spritzgußgebildes des Leitermusters 3 und gegebenenfalls zuvor auch zur Herstellung der Schaltungsträgerplatte 2 im Bereich der die Anschlußbereiche 13 aufweisenden Seitenkante der Schaltungsplatte so ausgebildet ist, daß in die Spritzgußform das Bandkabel 14 mit den aus seinem stirnseitigen Ende hervorstehenden Isolationsmänteln 16 einlegbar ist, so daß die freiliegenden Leiterenden 15 in die Formhohlräume hineinragen, die nach dem Einbringen des Leitkunststoffes für die Bildung des Leitermusters 3 vorgesehen sind.

Bei der Ausführungsform nach den Figuren 3 und 3a verläuft das vorzugsweise flexible Bandkabel 14 derart auf den die Anschlußbereiche 13 aufweisenden Rand der Schaltungsplatte 2 hin, daß die Leiter 15 zumindest nahe dem Kabelende in der Ebene der Schaltungsplatte oder in einer Parallelebene hierzu gelegen sind.

Gemäß einer abgewandelten Ausführungsform, welche in den Figuren 4 und 4a gezeigt ist, ist die Schaltungsträgerplatte 2 dort, wo Anschlußbereiche der Leiterbahnen des Leitermusters 3 vorgesehen sind, mit Bohrungen versehen, welche mit 17 bezeichnet sind und welche sich bei der Herstellung des Leitermusters als Kunststoff-Spritzgußgebilde aufgrund entsprechender Formgebung der Spritzgußform ebenfalls mit leitfähigem Kunststoff füllen.

In diese Bohrungen ragen die von jeder Isolation befreiten Leiterenden 15 des Bandkabels 14 hinein und werden von dem leitfähigen Kunststoff der Leiterbahnen des Leitermusters unmittelbar umschlossen. Dabei kann sich der leitfähige Kunststoff, wenn die Spritzgußform entsprechende Gestaltung aufweist, auch jeweils hülsenförmig um den Isolationsmantel 16 der einzelnen Leiter legen, um den mechanischen Halt zwischen der Schaltungsplatte 2 und dem Bandkabel 14 zu verbessern, wobei dafür Sorge getragen ist, daß der in den Bohrungen 17 befindliche leitfähige Kunststoff zur Bildung der Anschlußbereiche zwischen benachbarten Leiterbahnen keine Leiterbrücke ausbildet.

Die in den Figuren 4 und 4a gezeigte Konstruktion gestattet es, das Bandkabel 14 von den durch die Bohrungen 17 gebildeten Anschlußbereichen der Schaltungsplatte 2 zu dieser etwa senkrecht nach unten oder nach oben wegzuführen. Der Fachmann erkennt, daß sowohl bei der Ausführungsform nach den Figuren 3 und 3a als auch bei dem Ausführungsbeispiel nach den Figuren 4 und 4a mit der Schaltungsplatte 2 fest verbundene mechanische Klemmvorrichtungen vorgesehen sein können, die die Anschlußbereiche zwischen dem Bandkabel 14 und den Leiterbahnen des Leitermusters 3 von mechanischen Beanspruchungen entlasten.

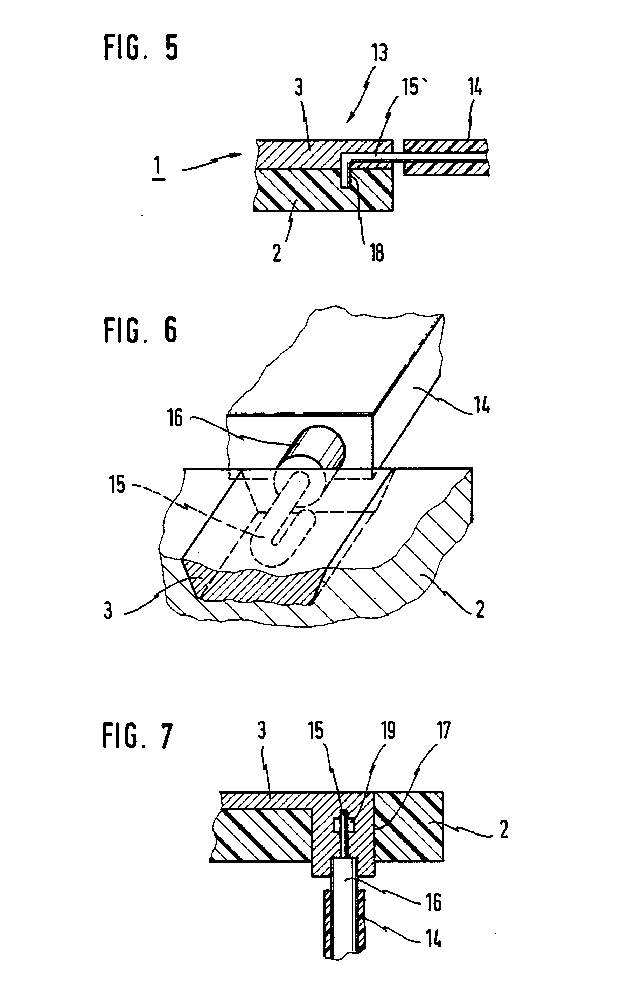

Die Figuren 5 bis 7 zeigen verschiedene Möglichkeiten auf, um zwischen den Leiterenden 15 des mehradrigen Kabels, insbesondere des Bandkabels 14 und dem die Leiterenden unmittelbar umschließenden, im Spritzgußverfahren eingebrachten leitfähigen Kunststoff eine zuverlässige mechanische Verbindung zu schaffen. Dabei zeigen die Figuren 5 bis 7 die hierzu in besonderer Weise gestalteten Anschlußbereiche.

Bei der besonderen Ausgestaltung der Anschlußbereiche gemäß Figur 5, welche sich für Schaltungsplatten nach der Ausführungsform gemäß den Figuren 3 und 3a eignet, ist die Schaltungsträgerplatte 2 in den Anschlußbereichen 13 mit Sackbohrungen 18 versehen, in die die abgewinkelten Enden der abisolierten Leiter 15 eingesteckt werden, bevor der leitfähige Kunststoff zur Bildung des Leitermusters 3 in die entsprechenden Formhohlräume der Spritzgußform eingebracht wird. Ein etwa auf das Bandkabel 14 einwirkender Zug gegenüber der Schaltungsplatte 1 wird in erster Linie durch die formschlüssige Verbindung zwischen den hakenförmigen Enden der Leiter 15 und den Sackbohrungen 18 der Schaltungsträgerplatte 2 und erst in zweiter Linie durch die Haftung zwischen dem Leitermaterial der Leiter 15 und dem leitfähigen Kunststoff des Leitermusters 3 aufgenommen.

Gemäß einer Weiterbildung der in den Figuren 3 und 3a gezeigten Ausführungsform können die Leiterenden 15 zur Verbesserung der Haftung im leitfähigen Kunststoff des Leitermusters 3 in den Anschlußbereichen auch am Vorderende hackenförmig umgebogen sein, wie in Figur 6 dargestellt ist.

Schließlich zeigt Figur 7 eine Weiterbildung der in den Figuren 4 und 4a gezeigten Ausführungsform dahingehend, daß an den Leiterenden 15 im Bereich der Bohrungen 17 der Schaltungsträgerplatte 2 aufgeklemmte Hülsen 19 befestigt sind, die als Verankerungsmittel gegenüber dem leitfähigen Kunststoff der Leiterbahnen des Leitermusters 3 in den Anschlußbereichen dienen.

Abweichend von den in den Figuren 3 und 4 gezeigten Ausführungsbeispielen können mehr als ein einziges Bandkabel 14 mit den Schaltungsplatten 1 in der hier beschriebenen Art und Weise verbunden werden und von mehreren Seiten her bzw. längs verschiedener Seitenränder mit der betreffenden Schaltungsträgerplatte elektrisch und mechanisch verbunden sein.

**Ansprüche**

1. Schaltungsplatte, insbesondere für Tastenwahlblöcke, mit einer aus Isolierwerkstoff bestehenden Schaltungsträgerplatte (2), welche an mindestens einer Oberfläche ein Leitermuster (3) aufweist, dadurch gekennzeichnet, daß die Schaltungsträgerplatte (2) als Kunststoff-Spritzgußteil ausgebildet ist, welches das Leitermuster (3) als innig mit der Schaltungsträgerplatte verbundenes Kunststoff-Spritzgußgebildet aus leitfähigem Kunststoff trägt.

2. Schaltungsplatte nach Anspruch 1, dadurch gekennzeichnet, daß das Leitermuster (3) in Vertiefungen der Schaltungsträgerplatte (2) derart eingebettet ist, daß seine Oberfläche mit der benachbarten Oberfläche der Schaltungsträgerplatte (2) mindestens bereichsweise bündig ist.

3. Schaltungsplatte nach Anspruch 1, dadurch gekennzeichnet, daß das Leitermuster mindestens bereichsweise auf einer ebenen Oberfläche der Schaltungsträgerplatte erhaben aufgebracht ist.

4. Schaltungsplatte nach einem der Ansprüche 1 bis 3, dadurch gekennzeichnet, daß in den Anschlußbereichen (13) des Leitermusters (3) der leitfähige Kunststoff von einer isolierenden Umhüllung (14, 16) befreite Leiterenden (15) oder Kontaktenden eines mehradrigen Kabels (14) unmittelbar umgibt.

5. Schaltungsplatte nach Anspruch 4, dadurch gekennzeichnet, daß die Anschlußbereiche (13) des Leitermusters (3) auf der Schaltungsplatte (2) im wesentlichen in einer Reihe nebeneinanderliegen und daß das mehradrige Kabel (14) ein flexibles Vielleiter-Bandkabel (14) ist.

6. Schaltungsplatte nach Anspruch 4 oder 5, dadurch gekennzeichnet, daß die den Anschlußbereichen (13) zugeordneten Leiterbahnen des Leitermusters (3) bis zu einem Rand de Schaltungsplatte (1) verlaufen und daß die Leiter (15) des Kabels bzw. des Vielleiter-Bandkabels (14) etwa in der Ebene der Schaltungsplatte verlaufend derart auf die Schaltungsplatte treffen, daß die Leiterenden (15) oder Kontaktenden in den Leitkuststoff der Leiterbahnen hineinragen.

7. Schaltungsplatte nach Anspruch 4 oder 5, dadurch gekennzeichnet, daß die Anschlußbereiche (13) innerhalb von mit den Leiterbahnen des Leitermusters (3) verbundenen Bohrungen (17) der Schaltungsträgerplatte (2) gelegen sind und daß die Leiter (15) des Kabels bzw. des Vielleiter-Bandkabels (14) im wesentlichen senkrecht zur Ebene der Schaltungsplatte (1) verlaufend derart auf die Schaltungsplatte treffen, daß die Leiterenden (15) oder Kontaktenden in die mit dem Leitkunststoff der Leiterbahnen des Leitermusters (3) ausgefüllten Bohrungen (17) der Schaltungsträgerplatte (2) hineinragen.

8. Schaltungsplatte nach einem der Ansprüche 4 bis 7, dadurch gekennzeichnet, daß die Leiterenden (15) oder Kontaktenden mit von Leitkunststoff der Leiterbahnen des Leitermusters (3) umgebenen Verankerungsmitteln (9) versehen sind.

9. Schaltungsplatte nach einem der Ansprüche 4 bis 7, dadurch gekennzeichnet, daß die Leiterendem (15) oder Kontaktenden mit an Verankerungsmitteln (18) der Schaltungsträgerplatte (2) in den Anschlußbereichen (13) zusammenwirkenden Gegen-Verankerungsmitteln versehen sind.

10. Verfahren zur Herstellung einer Schaltungsplatte nach einem der Ansprüche 1 bis 9, dadurch gekennzeichnet, daß zunächst in einer ersten Spritzgußform die Schaltungsträgerplatte (2) hergestellt und dann in einer zweiten Spritzgußform das Leitermuster an die Schaltungsträgerplatte angespritzt wird.

11. Verfahren nach Anspruch 10, dadurch gekennzeichnet, daß in der ersten Spritzgußform die Schaltungsträgerplatte mit Vertiefungen gebildet und in der zweiten Spritzgußform die Oberfläche der Schaltungsträgerplatte gegen eine ebene Formwand der zweiten Sprtizgußform angepreßt wird, wobei die Vertiefungen der gebildeten Schaltungsträgerplatte die Formhohlräume zur Herstellung des Leitermusters in der zweiten Spritzgußform bilden.

FIG. 1

FIG. 2a

FIG. 2b

FIG. 3

FIG. 3a

0 226 904

FIG. 4

FIG. 4a

**FIG. 5**

**FIG. 6**

**FIG. 7**